# EUROPÄISCHE PATENTANMELDUNG

(11) **EP 1 207 548 A2**
(43) Veröffentlichungstag der Anmeldung: **22.05.2002**
(21) Anmeldenummer: 01127047.7
(22) Anmeldetag: 14.11.2001
(51) Int. Cl.: H01L 21/00

(54) **Verfahren und Vorrichtung zum Be- und Entladen von Halbleiterwafern**

(30) Priorität: 15.11.2000 DE 10056544
(71) Anmelder: Infineon Technologies AG, 81669 München (DE)
(72) Erfinder: Aigner, Kurt, 9073 Viktring (AT); Binder, Alfred, 9500 Landskron (AT); Fertschei, Annemarie, 9500 Villach (AT); Giovannini, Alberto, 73602 Schorndorf (DE); Golubic, Richard, 9585 Techanting (AT); Kroupa, Gerhard, 9500 Villach (AT); Matschitsch, Martin, 9181 Feistritz i. Ros. (AT); Kerhe, Marian, 8500 Villach (AT); Ladinig, Marcello, 9170 Ferlach (AT); Manzoni, Giulio, 8500 Villach (AT); Rudolf, Conny-Norbert, 93049 Regensburg (DE); Scherf, Werner, 8130 Frohnleiten (AT); Unterweger, Josef, 8520 Annenheim (AT); Wöhlert, Stefan, 9500 Villach (AT); Zerlauth, Stefan, 9020 Klagenfurt (AT)
(74) Vertreter: Müller - Hoffmann & Partner

(57) **Zusammenfassung**

Zum besonders schonenden Be- und Entladen von Halbleiterwafern (19) in/aus Aufnahmeeinheiten (4) wird bei einem entsprechenden Verfahren/einer Vorrichtung vorgeschlagen, die Halbleiterwafer (19) eim Einsetzen/Entnehmen gegenüber einer Ausnehmung (4a) einer Aufnahmeeinheit (4) im Wesentlichen zentriert und im Wesentlichen parallel und/oder eben ausgerichtet anzuordnen.

## Beschreibung

Die Erfindung betrifft ein Verfahren zum Be- und Entladen von Halbleiterwafern, insbesondere Dünnwafer oder dergleichen, in bzw. aus Aufnahmeeinheiten gemäß dem Oberbegriff des Anspruchs 1 sowie eine Vorrichtung zum Be- und Entladen von Halbleiterwafern in bzw. aus Aufnahmeeinheiten gemäß dem Oberbegriff des Anspruchs 12, insbesondere zur Ausführung des erfindungsgemäßen Verfahrens.

Bei der Halbleiterherstellung sind für manche Verarbeitungsschritte oder Prozesse, z.B. der Metallisierung in Bedampfungsanlagen, besondere Aufnahmeeinheiten für Wafer, z.B. sogenannte Kalotten oder dergleichen, erforderlich. Zum Beladen dieser Kalotten müssen die Wafer z.B. aus sogenannten Horden entnommen und in Nester der Kalotte eingesetzt und eingeklemmt werden. Nach der Behandlung werden die Wafer aus den Nestern der Kalotte entnommen oder entladen und dann z.B. entweder in Quarzbooten oder wieder in Horden abgelegt. Für das Entnehmen von Wafern aus Horden und für das Einsetzen von Wafern in Quarzboote werden z.B. Greifer, sogenannte "Löffel" verwendet.

Der Erfindung liegt die Aufgabe zugrunde, ein Verfahren und eine Vorrichtung der eingangs genannten Art anzugeben, mit welchen das Beladen von Aufnahmeeinheiten, insbesondere von Kalotten oder dergleichen, mit Wafern und das Entnehmen von Wafern aus Kalotten einfach und insbesondere durch das Prinzip der Zwangsübergabe möglich sind.

Die Aufgabe wird verfahrensmäßig durch ein gattungsgemäßes Verfahren zum Be- und Entladen von Halbleiterwafern erfindungsgemäß mit den kennzeichnenden Merkmalen des Anspruches 1 und vorrichtungsmäßig durch eine gattungsgemäße Vorrichtung zum Be- und Entladen von Halbleiterwafern mit den kennzeichnenden Merkmalen des Anspruchs 12 gelöst.

Bevorzugte und vorteilhafte Ausgestaltungen des erfindungsgemäßen Verfahrens und der erfindungsgemäßen Vorrichtung sind jeweils Gegenstand der abhängigen Unteransprüche.

Beim gattungsgemäßen Verfahren zum Be- und Entladen von Halbleiterwafern, insbesondere Dünnwafern oder dergleichen, in bzw. aus Aufnahmeeinheiten werden Halbleiterwafer in oder aus Ausnehmungen einer Aufnahmeeinheit eingesetzt bzw., insbesondere nach einem Bearbeitungsschritt oder dergleichen, entnommen.

Das erfindungsgemäße Verfahren zum Be- und Entladen von Halbleiterwafern ist dadurch gekennzeichnet, dass der Halbleiterwafer beim Einsetzen und/oder beim Entnehmen in eine bzw. aus einer Ausnehmung gegenüber der Ausnehmung jeweils im wesentlichen zentriert angeordnet wird und dass der Halbleiterwafer während des Einsetzens und/oder Entnehmens in die bzw. aus der Ausnehmung jeweils in einer zur Ausnehmung im wesentlichen parallelen und/oder ebenen Ausrichtung gehalten wird. Dadurch wird erfindungsgemäß erreicht, dass das eigentliche Bewegen des jeweiligen Halbleiterwafers auf die Ausnehmung zu oder von ihr weg erfolgen kann, ohne dass nennenswerte Berührungen, insbesondere der Unterseite des jeweiligen Halbleiterwafers, und somit Beschädigungen der jeweiligen Oberfläche auftreten. Dies ermöglicht ein besonders einfaches und schnelles Beladen und Entladen der Wafer aus den Aufnahmeeinheiten.

Dabei ist es insbesondere bevorzugt, dass das Verfahren zum Be- und/oder Entladen von als Kalotten ausgebildeten Aufnahmeeinheiten mit einer Mehrzahl von als Nester ausgebildete Ausnehmungen vorgesehen und geeignet ist. Dies ist deshalb vorteilhaft, weil sich gerade Kalotten mit Nestern als Ausnehmungen als Aufnahmeeinheiten bei der Massenproduktion von Halbleiterwafern anbieten und durchgesetzt haben.
Es ist weiter von Vorteil, dass gemäß einer weiteren Ausführungsform dieses erfindungsgemäßen Verfahrens der Halbleiterwafer bei einer Bewegung von und/oder zur Ausnehmung auf einer Seite gehalten wird, die nicht zu behandeln ist bzw. nicht behandelt wurde. Dadurch wird ebenfalls ein Beschädigen oder Verunreinigen der zu behandelnden oder der behandelten Oberfläche weitestgehend vermieden, und die Bewegung selbst und somit das Be- und/oder Entladen kann zügig erfolgen.

Ein besonders sicheres Handhaben ohne nennenswerte mechanische Insulzien auf die jeweiligen Oberflächen ergibt sich, wenn gemäß einer weiteren Ausführungsform des erfindungsgemäßen Verfahrens der Halbleiterwafer jeweils durch Einwirken von Unterdruck und/oder durch Einwirken von durchströmendes Gas, insbesondere nach dem Benoulli-Prinzip entstehende Kräfte ausgerichtet und insbesondere eben gehalten oder planarisiert wird, insbesondere während er bewegt wird.

Für eine gute Anpassung und ein gutes Einsetzen bzw. Entnehmen eines Halbleiterwafers wird es bevorzugt, dass der Halbleiterwafer auf einer der Ausnehmung, in welche oder von welcher er einzusetzen bzw. zu entnehmen ist, zugekehrten Seite gehalten wird. Dies sichert ein Abstützen beim zu Bewegen auf die Ausnehmung bzw. beim Fortbewegen von der Ausnehmung.

Gemäß einer weiteren Ausführungsform ist es vorgesehen, dass der Halbleiterwafer durch Halten an dieser Unterseite in bezug auf die Ausnehmung bewegt und/oder zentriert wird.

Ein besonders schonendes Einsetzen bzw. Entnehmen eines Halbleiterwafers ergibt sich, wenn gemäß einer anderen Ausführungsform des erfindungsgemäßen Verfahrens die auf den Halbleiterwafer einwirkenden Kräfte während des Ausrichtens gegenüber der Ausnehmung im wesentlichen aufgehoben werden, insbesondere bevor der Halbleiterwafer jeweils endgültig in der Ausnehmung angeordnet wird oder ist.

Entsprechend werden beim Entladen von Halbleiterwafern aus Ausnehmungen einer Aufnahmeeinheit die Verfahrensschritte im Wesentlichen in sinngemäß umgekehrter Vorgehensweise oder Verfahrensweise ausgeführt wie beim Beladen der Aufnahmeeinheit.

Eine für weitere Verarbeitungsschritte sowie für das Einsetzen und Entnehmen besonders günstige Vorgehensweise ergibt sich, wenn der Halbleiterwafer nach dem Beladen in der Ausnehmung durch wenigstens in seinem Randbereich auf ihn wirkende und/oder zur Ausnehmung im wesentlichen senkrecht ausgerichtete Kräfte gehaltert, insbesondere geklemmt wird. Dadurch wird zum Beispiel auch erreicht, dass ausschließlich in diesen Randbereichen, welche gegebenenfalls relativ schmal und in ihrem Flächenanteil gering ausgelegt werden können, mechanische Belastungen oder Insulzien auftreten.

Gemäß einer weiteren Ausführungsform des erfindungsgemäßen Verfahrens wird die Aufnahmeeinheit in eine Be- bzw. Entladeposition oder -stellung bewegt. Ferner wird die jeweils zu be- und/oder entladende Ausnehmung der Aufnahmeeinheit durch Verdrehen der Aufnahmeeinheit um eine Achse in die Be- oder Entladeposition bewegt.

Bei der erfindungsgemäßen Vorgehensweise wird bevorzugt, dass beim Entladen eines Halbleiterwafers aus einer Ausnehmung der Ausnahmeeinheit der Halbleiterwafer jeweils in einer im wesentlichen parallelen und/oder ebenen Lage zur Ausnehmung gehalten wird, vorzugsweise durch strömendes Gas und/oder durch nach dem Benoulli-Prinzip entstehende Kräfte, bevor den Halbleiterwafer jeweils in der Ausnehmung halternde und/oder klemmende Kräfte aufgehoben werden.

Die erfindungsgemäße Vorrichtung zum Be- und/oder Entladen von Halbleiterwafern, insbesondere Dünnwafern oder dergleichen, in bzw. aus Aufnahmeeinheiten ist insbesondere zur Ausführung des erfindungsgemäßen Verfahrens geeignet und dadurch gekennzeichnet, dass eine Halteeinrichtung für mindestens eine Aufnahmeeinheit vorgesehen ist, mit welcher die Aufnahmeeinheit in eine Be- und/oder eine Entladeposition bewegbar ist. Es ist ferner vorgesehen, dass im Bereich der Be- und/oder Entladeposition mindestens eine Übergabeeinrichtung vorgesehen ist, welche in Richtung einer Achse einer Ausnehmung in der Aufnahmeeinheit gegenüber der Ausnehmung verstellbar ist. Des Weiteren ist es vorgesehen, dass wenigstens eine Beladeeinrichtung und/oder wenigstens eine Entladeeinrichtung zum Bewegen von Halbleiterwafern zu bzw. von einer in der Be- bzw. Entladeposition befindlichen Aufnahmeeinheit vorgesehen sind. Durch das Kooperieren der Halteeinrichtung der Übergabeeinrichtung sowie der Be- und Entladeeinrichtung wird erreicht, dass eine gegebene Aufnahmeeinheit besonders rasch und auf einfache Art und Weise unter weitestgehender Vermeidung mechanischer Einflüsse auf die Halbleiterwafer mit Halbleiterwafern beladen oder von diesen entladen werden kann.

Die erfindungsgemäße Vorrichtung ist vorzugsweise zum Be- und/oder Entladen von als Kalotten oder dergleichen ausgebildete Aufnahmeeinheiten mit einer Mehrzahl fester oder dergleichen ausgebildeter Ausnehmungen vorgesehen und geeignet.

Als Übergabeeinrichtung ist insbesondere eine solche vorgesehen, die im wesentlichen als Übergabezylinder oder dergleichen ausgebildet ist oder mindestens einen solchen aufweist.

Es ist des Weiteren vorgesehen, dass die mindestens eine Beladeeinrichtung und/oder die mindestens eine Entladeeinrichtung jeweils im wesentlichen als Be- bzw. als Entladelöffel oder dergleichen ausgebildet sind oder jeweils einen solchen aufweisen.

Gemäß einer weiteren Ausführungsform der erfindungsgemäßen Vorrichtung ist es vorgesehen, dass die Beladeeinrichtung aus einer einem ersten Halbleiterreservoir, insbesondere einer Horde oder dergleichen, zugeordneten Stellung in die der Be- und/oder Entladeposition der Aufladeeinheit zugeordneten Stellung und von dort zurückbewegbar ausgebildet ist.

Entsprechend ist es vorgesehen, dass die Entladeeinrichtung aus einer der Be- bzw. Entladeposition der Aufnahmeeinheit zugeordneten Stellung in eine einem zweiten Halbleiterwaferreservoir, insbesondere einem Quarzboot oder dergleichen, und/oder einer Horde oder dergleichen zugeordneten Stellung und von dort zurückbewegbar ausgebildet ist.

Die beiden zuletzt genannten Maßnahmen schaffen eine hohe Flexibilität und Beweglichkeit der jeweiligen Be- und/oder Entladeeinrichtungen und ermöglichen somit eine hohe Verarbeitungsrate.

Um die jeweiligen Bewegungen der Be- und/oder Entladeeinrichtungen zu gewährleisten, ist es gemäß einer weiteren Ausführungsform der erfindungsgemäßen Vorrichtung vorgesehen, jeweils mindestens eine Bewegungseinrichtung auszubilden. Diese kann vorteilhafterweise als Bewegungsroboter oder dergleichen vorgesehen sein.

Zur Gewährleistung einer sicheren Weiterverarbeitung und eines sicheren Transportes ist es gemäß einer weiteren Ausführungsform der erfindungsgemäßen Vorrichtung vorgesehen, dass mindestens eine Haltevorrichtung zum Halten mindestens einer Aufnahmeeinheit in der Be- und/oder Entladeposition ausgebildet ist.

Vorteilhafterweise weist die eine Haltevorrichtung mindestens einen verschwenkbaren Arm auf oder ist als solcher ausgebildet. Ferner ist es vorgesehen, dass an dem Arm ein von innen her an der Aufnahmeeinheit anlegbarer Greifer oder dergleichen und/oder eine an der Aufnahmeeinheit außen an einem vorgesehenen Adapter oder dergleichen angreifende Klemme oder dergleichen ausgebildet sind.

Es ist ferner von Vorteil, dass durch den Arm die Aufnahmeeinheit um ihre Achse verdrehbar halterbar ist. Ferner ist es vorgesehen, dass der Arm in einem Lager um eine Achse, gegebenenfalls durch motorischen Antrieb oder dergleichen, verschwenkbar ausgebildet ist.

Dabei wird bevorzugt, dass der Haltevorrichtung zum Haltern von Aufnahmeeinheiten, insbesondere bestehend aus dem Arm, dem vorzugsweise selbstzentrierenden Greifer und der Klemme, ein Drehtisch mit mehreren Halterungen für Adapter einer Mehrzahl von Aufnahmeeinheiten zugeordnet vorgesehen ist.

Es ist ferner von Vorteil, dass der sich in der Be- bzw. Entladestellung befindlichen Ausnehmung der Aufnahmeeinheit eine Übergabeeinrichtung, insbesondere ein Übergabezylinder oder dergleichen, zugeordnet vorgesehen ist.

Dabei wird bevorzugt, dass die Übergabeeinrichtung, insbesondere der Übergabezylinder einen Kopf aufweist, der in eine zur Ebene der Ausnehmung parallele Lage oder Anordnung verstellbar ausgebildet ist. Dies ermöglicht ein entsprechendes Vor- und Zurückbewegen um einen zu positionierenden Halbleiterwafer entsprechend sanft abzustützen und in der Ausnehmung der Aufnahmeeinheit zu positionieren oder ihn aus dieser herauszuheben.

Es ist ferner vorteilhaft, dass an dem der Ausnehmung zugekehrten Ende der Übergabeeinrichtung wenigstens ein Vakuumkopf und/oder wenigstens eine Düse für den Austritt von Druckgas vorgesehen ist.

Dieser Vakuumkopf und/oder die Düse sind zum Erzeugen von Kräften nach dem Benoulli-Prinzip ausgebildet und somit geeignet, ein möglichst sanftes Haltern und Lagern eines zu positionierenden Halbleiterwafers zu gewährleisten.

Ebenfalls zu einer besonders günstigen Positionierbarkeit ist es vorgesehen, dass an dem der Ausnehmung jeweils zugekehrten Ende der Übergabeeinrichtung Referenzanschläge vorgesehen sind, welche gegenüber der Ausnehmung verschiebbar ausgebildet sind.

Des Weiteren ist vorgesehen, dass der Kopf der Übergabeeinrichtung an einem äußeren, in etwa zylindrischen Teil der Übergabeeinrichtung im wesentlichen elastisch verschwenkbar gehaltert ist.

Dabei ist es ferner von Vorteil, dass an dem Kopf mehrere Anschlagstifte vorgesehen sind, welche zum Zentrieren des Kopfes der Übergabeeinrichtung, insbesondere im Umfangsbereich einer Ausnehmung, an der Aufnahmeeinheit anlegbar vorgesehen sind.

Es ist gegebenenfalls jeder Ausnehmung der Aufnahmeeinheit eine einen Halbleiterwafer in der Ausnehmung fixierende Fixiereinrichtung, insbesondere als eine in das Nest klemmende Vorrichtung, zugeordnet vorgesehen. Dadurch wird ein Haltern und Fixieren des jeweiligen Halbleiterwafers, insbesondere während eines weiterverarbeitenden Prozessschrittes gewährleistet.

Es ist bevorzugt, dass die Fixiervorrichtung, insbesondere zum Klemmen eines Halbleiterwafers in einem Nest, eine an einem Schwenkhebel gegenüber diesem kippbar gelagerte Scheibe aufweist. Weiterhin vorteilhaft ist, dass mit Abstand von der Scheibe unterhalb des Schwenkhebels eine Zentrierscheibe mit nach unten abgewinkeltem Rand vorgesehen ist, um die Scheibe gegenüber dem Halbleiterwafer parallel zu stellen, bevor die Scheibe im Halbleiterwafer anliegt.

Alternativ und/oder zusätzlich ist es vorgesehen, dass die Fixiervorrichtung jeweils einen, insbesondere wenigstens einmal unterbrochenen, Klemmring aufweist. Dabei ist vorteilhaft, dass der Klemmring über einen Haltebügel und einen Schwenkhebel an der Aufnahmeeinheit, insbesondere Kalotte oder dergleichen, verschwenkbar gelagert ist.

Ferner ist es dabei von Vorteil, dass der Klemmring mit dem Haltebügel durch elastische Mittel, insbesondere durch Blattfedern oder dergleichen, verbunden ist.

Mit dem erfindungsgemäßen Verfahren wird durch die sinnvolle Abstimmung der einzelnen Stufen des Verfahrens ein schonendes Handhaben auch dünner und/oder großer Wafer gewährleistet, wobei auch sichergestellt ist, dass das Beladen und das Entladen der Kalotten durch Einsetzen von Wafern in die Nester bzw. das Entnehmen von Wafern aus den Nestern in kurzer Zeit möglich ist.

Die bei dem Verfahren und mit der Vorrichtung gemäß der Erfindung verwirklichte Zwangsübergabe von Wafern erlaubt es, dass bei der Übergabe von Wafern vom Greifer zu einer Einrichtung, die beispielsweise ein Übergabezylinder ist und die den Wafer jeweils übernimmt und in ein Nest der Kalotte bewegt und umgekehrt, zum Zeitpunkt der Übergabe beide Systeme aktiv sind. Dabei wird der Wafer jeweils hauptsächlich nur an einer Seite, vorzugsweise der Rückseite, berührt. Weiterhin ist durch die verwendete Vorgehensweise eine relativ kurze Taktzeit möglich.

Weitere Einzelheiten und Merkmale des erfindungsgemäßen Verfahrens und der Vorrichtung ergeben sich aus der nachstehenden Beschreibung von in den Zeichnungen gezeigten Ausführungsbeispielen.
- Fig. 1: ist eine schematische und perspektivische Gesamtansicht einer Anordnung gemäß der Erfindung, auf der insbesondere das Verfahren ausgeführt werden kann.
- Fig. 2: zeigt ein Flussdiagramm einer Ausführungsform des erfindungsgemäßen Verfahrens.
- Fig. 3: zeigt in einer perspektivischen und teilweise geschnittenen Seitenansicht eine Vorrichtung (Übergabezylinder) zum Einsetzen/Entnehmen von Wafern in das/aus einem Nest.
- Fig. 4: zeigt eine Ausführungsform einer Einrichtung zum Halten eines Wafers in einem Nest einer Kalotte.
- Fig. 5: zeigt eine weitere Ausführungsform einer Einrichtung zum Halten eines Wafers in einem Nest einer Kalotte.
- Fig. 6: zeigt eine selbstzentrierende Vorrichtung zum Betätigen der Einrichtungen gemäß Fig. 4 oder 5.

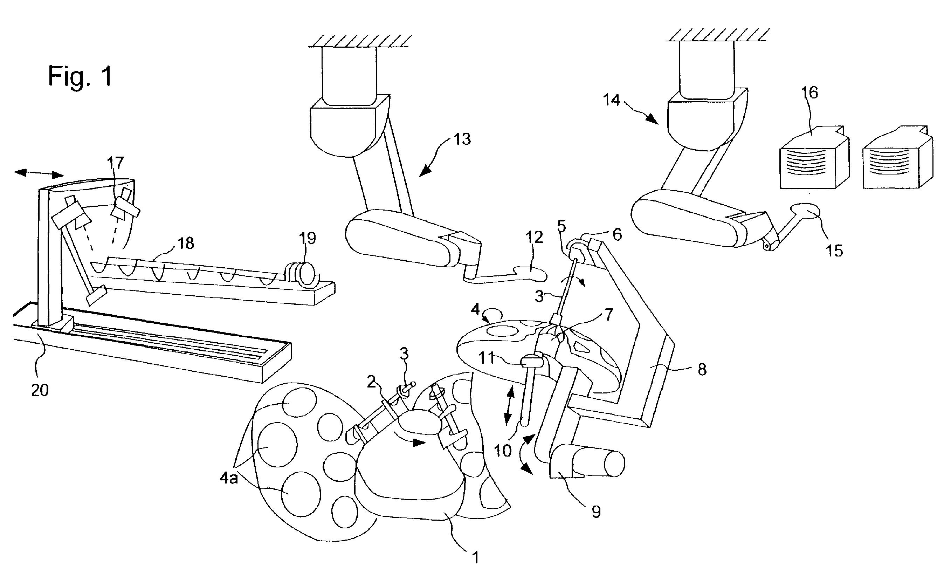

Die in Fig. 1 gezeigte Anordnung umfasst einen Drehtisch 1. An dem Drehtisch 1 sind mehrere Halterungen 2 (z.B. vier Halterungen 2) vorgesehen. Die Halterungen 2 sind zum Halten jeweils einer Kalotte 4 bestimmt. Hierzu sind die Kalotten 4 mit Adaptern 3 ausgestattet, die an den Halterungen 2 festgelegt werden können. Durch Verdrehen des Drehtisches 1 wird eine Kalotte 4 mit ihrem Adapter 3 so ausgerichtet, dass die Kalotte 4 von einem in einem Lager 9 verschwenkbar gelagerten Arm 8 erfasst und vom Drehtisch 1, d.h. aus den Halterungen 2 desselben heraus, abgenommen werden kann. Der Arm 8, der mit Hilfe eines Motors verschwenkbar ist, besitzt einerseits einen selbstzentrierenden Greifer 7, der von der hohlen (inneren) Seite der Kalotte 4 her an dieser im Bereich des an der Kalotte 4 befestigten Endes des Adapters 3 angreift. Am freien Ende des Armes 8 ist eine Klemme 6 vorgesehen, die so verstellt wird, dass sie an einem am freien Ende des Adapters 3 vorgesehenen Drehlager 5 angreift.

Der selbstzentrierende Greifer 7 und das Lager 5, das in der Klemme 6 am Arm 8 aufgenommen ist, erlauben, dass die Kalotte 4 um ihre Achse drehbar ist, um eines ihrer Nester 4a in die Position auszurichten, in der ein Wafer 19 in das Nest 4a eingesetzt bzw. aus dem Nest 4a entnommen werden kann. Dabei sind Sensoren vorgesehen, welche die Lage der Kalotte 4 und insbesondere des Nestes 4a, in das ein Wafer 19 eingesetzt oder aus dem ein Wafer 19 entnommen werden soll, feststellen.

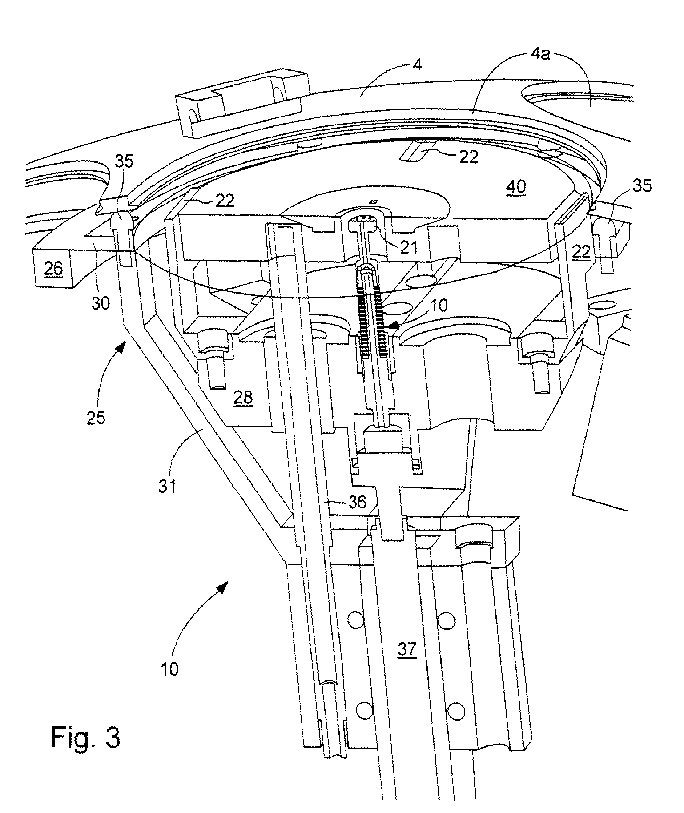

Dem Arm 8, der eine Kalotte 4 in der Lade- bzw. Entladeposition hält, ist ein Übergabezylinder 10 zugeordnet, der in mehr Einzelheiten später an Hand der Fig. 3 beschrieben werden wird und mit dem ein Wafer 19 von einem Beladelöffel 15, der an einem Beladeroboter 14 montiert ist, übernommen und durch Absenken des Übergabezylinders 10 in das Nest 4a eingesetzt werden kann. Der Beladelöffel 15 dient dazu, einzelne Wafer 19 aus einer Horde 16 zu entnehmen und dem Übergabezylinder 10 zwangsgesteuert zu übergeben.

In der Anordnung ist ein Entladelöffel 12 vorgesehen, der an einem Entladeroboter 13 gehaltert ist. Der Entladelöffel 12 übernimmt Wafer 19 von dem nach oben durch das Nest 4a hochgefahrenen Übergabezylinder 10 und bewegt den Wafer 19 in ein Quarzboot 18, wobei an der Halterung für das Quarzboot 18 Sensoren 17 (vorzugsweise optische-/Lasersensoren) vorgesehen sind, die den Schlitz im Quarzboot 18 identifizieren, in den der Wafer 19 vom Entladelöffel 12 eingesetzt werden kann. Der Lasersensor 17 ist durch eine Verschiebevorrichtung 20 entlang des Quarzbootes 18 verschiebbar.

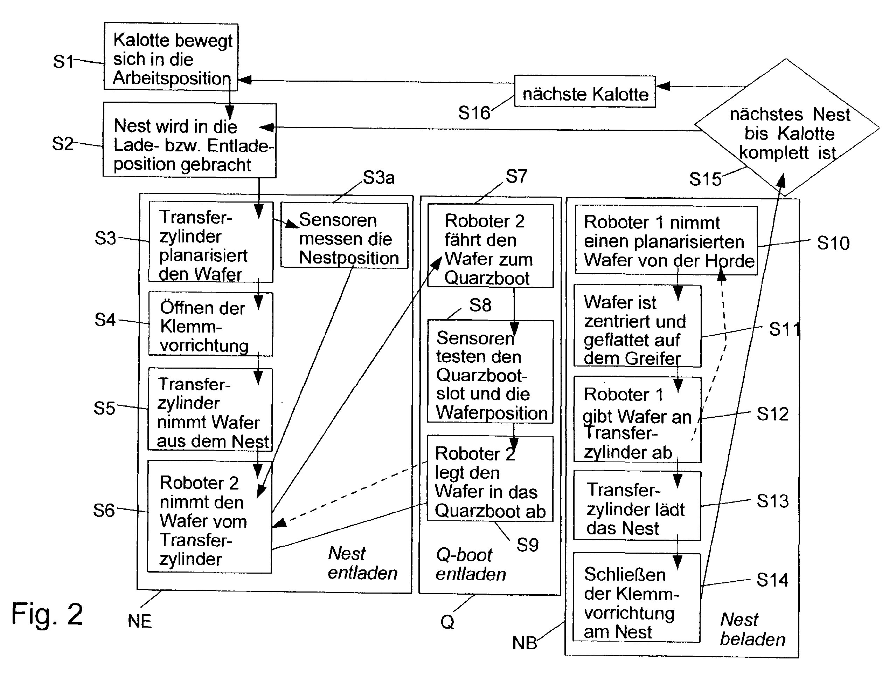

Mit der beschriebenen und in Fig. 1 gezeigten Anordnung kann so gearbeitet werden, wie dies nachstehend an Hand von Fig. 2 erläutert wird.

Der am Laderoboter 14 vorgesehene Löffel 15 entnimmt einen Wafer 19 aus der Horde 16, und zwar durch Greifen an der Waferrückseite. Der Wafer 19 wird dabei durch das verwendete Prinzip des Haltens mit einem Greifer gleichzeitig planarisiert.

Zusätzlich kann eine Station vorgesehen sein, bei welcher die Wafer geflattet, zentriert und/oder, insbesondere über Barcode, identifiziert werden. Diese Station kann zwischen der Horde 16 und dem Beladeroboter 14 vorgesehen sein.

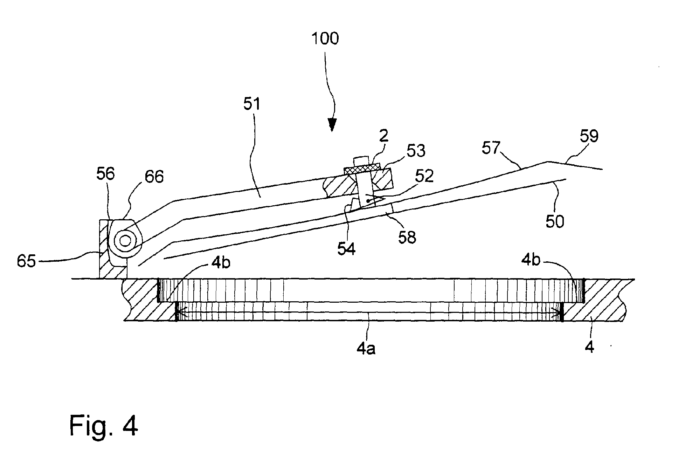

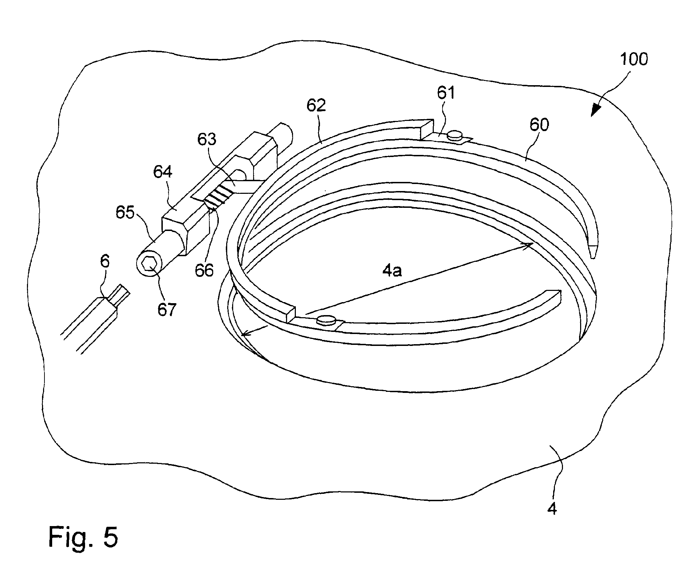

Die zu bearbeitende Seite des Wafers 19 muss im Nest 4a immer zum Kalotteninneren zeigen. Dazu wird der Laderoboter 14 automatisch so bewegt, dass der Beladelöffel 15 mit der zu bearbeitenden Seite des Wafers 19 zum zu beladenden Nest 4a hin ausgerichtet ist. Wenn der Beladelöffel 15 an der nicht zu bearbeitenden Seite des Wafers 19 greift - Vorderseite muss prozessiert werden, sie zeigt nach unten - senkt sich der Beladelöffel 15 und ordnet den Wafer 19 in das Nest 4a der Kalotte 4 an. Der Beladelöffel 15 lässt den Wafer 19 erst dann los, wenn der sich unter dem Nest 4a der Kalotte 4 befindliche Übergabezylinder 10 den Wafer 19 durch das Bernoulli-Prinzip planarisiert und stabilisiert. Nach dem Zurückfahren des Beladelöffels 15 aus dem Nest 4a der Kalotte 4 wird eine dem Nest 4a zugeordnete Klemmvorrichtung 100, die beispielsweise die nachstehend an Hand der Fig. 4 oder 5 beschriebene Ausführungsform haben kann, geschlossen und die Kalotte 4 so gedreht, dass das nächste Nest mit einem Wafer beschickt werden kann.

Ist der Beladelöffel 15 über dem zu beladenden Nest 4a ausgerichtet und greift er an der zu bearbeitenden Seite des Wafers 19 (Rückseite des Wafers) an, wird der Übergabezylinder 10 durch das Nest 4a in der Kalotte 4 ausgefahren und übernimmt den Wafer 19 vom Löffel 15 durch am Beladelöffel 15 vorgesehene Aussparungen. Der Beladelöffel 15, der sich jetzt noch zwischen den Wafer 19 und dem oberen Ende des Übergabezylinders 10 befindet, wird nun durch den Laderoboter 14 seitlich herausgefahren. Der Übergabezylinder 10 wird danach abgesenkt, damit der Wafer 19 im Nest 4a der Kalotte 4 angeordnet wird. Anschließend wird die dem Nest 4a zugeordnete Klemmvorrichtung 100 geschlossen und der Wafer 19 damit im Nest 4a der Kalotte 4 fixiert.

Der Übergabezylinder 10 fährt nach Abschalten der Haltefunktionen nach unten, und die Kalotte 4 wird bis zum nächsten zu beschickenden Nest 4a gedreht. Diese Arbeitsschritte werden fortgesetzt, bis alle Nester der Kalotte 4 mit Wafern 19 beschickt sind. Dann wird die Kalotte 4 zur weiteren Bearbeitung der in ihr gehalterten Wafer 19 in eine Arbeitsstation bewegt. Hierzu kann die Kalotte 4 wieder auf den Drehtisch 1 übergeben und auf nicht näher gezeigte Weise der Bearbeitungsstation nach Abnahme vom Drehtisch 1 zugeführt werden.

Sobald die Bearbeitung/Behandlung (das "Bearbeiten") der Wafer 19 auf der Kalotte 4 in der Bearbeitungsstation beendet ist, wird die Kalotte 4 wieder an den Drehtisch 1 angesetzt, von dem Drehtisch 1 auf den Arm 8 übergeben und in die in Fig. 1 gezeigte Lage bewegt, d.h. über ihren Adapter 3 von dem selbstzentrierenden Greifer 7 und der Klemme 6 gehalten und so ausgerichtet, dass das erste Nest 4a zum Entladen gegenüber dem Übergabezylinder 10 angeordnet ist. Der Übergabezylinder 10 wird mit seinem vorderen Ende dem zu entnehmenden Wafer 19 angenähert, und der Wafer 19 wird - abhängig vom Prozess - durch den Übergabezylinder 10 ergriffen (Rückseitenprozess) oder planarisiert/stabilisiert (Vorderseitenprozess). Darauf wird die Klemmvorrichtung 100 geöffnet. Hat der Übergabezylinder 10 den Wafer 19 ergriffen, fährt dieser durch das Nest 4a nach oben und übergibt den Wafer 19 an den Entladelöffel 12 durch rückwärtige Schrittabfolge des oben beschriebenen Beladeprozesses. Wurde der Wafer 19 durch den Übergabezylinder 10 nur planarisiert/stabilisiert, senkt sich der Entladelöffel 12 und übernimmt den Wafer 19 aus dem Nest 4a. Der Entladeroboter 13 setzt nun den Wafer 19 automatisch in das Quarzboot 18, wobei der Schlitz in dem Quarzboot 18, in das der Wafer 19 einzusetzen ist, durch geeignete Sensorik 17 - vorzugsweise optisch mittels Laser - lokalisiert wird.

Der Übergabezylinder 10, welcher der Kalotte 4 bzw. einem Nest 4a derselben zum Einsetzen bzw. Entnehmen von Wafern 19 in das Nest 4a zugeordnet ist, wird nachstehend an Hand von Fig. 3 näher beschrieben.

Der Übergabezylinder 10 besteht aus einem äußeren, zylinderförmigen Teil oder zylindrischem Außenmantel 26, einem mit diesem beweglich verbundenen Kopf 25, der aus einem äusseren Teil 31 und einem inneren Teil 28 besteht. Im äusseren Teil 31 des Kopfes 25 sind Führungsstangen 36 befestigt, auf denen der innere Teil 28 des Kopfes 25 verschiebbar ist und die an ihren freien Enden eine Halteeinrichtung 40 für Wafer 19 tragen. Weiterhin sind die Führungsstangen 36 hohl und führen Druckluft für den an der Halteeinrichtung 40 befindlichen Bernoulli-Ring. Der innere Teil 28 des Kopfes 25 mit seinen drei Referenzanschlägen 22 und dem in der Mitte befestigten Vakuumkopf 21 kann über das Nest 4a der Kalotte 4 ausgefahren werden, einen Wafer 19 vom Beladelöffel 15 übernehmen und wieder in das Nest 4a einfahren. Beim Entladen gibt der innere Teil 28 des Kopfes 25 einen Wafer 19 an den Entladelöffel 12 ab. Im Bereich der Referenzanschläge 22 oder die Referenzanschäge 22 selbst können mit einer Vakuumfunktion versehen sein.

Der Kopf 25 des Übergabezylinders 10 ist über eine ringförmige (Blatt-)Feder 30 elastisch verschwenkbar am Übergabezylinder 10 montiert. Der Übergabezylinder 10 ist durch Verschieben seines zylindrischen Außenmantels 26 auf und ab verstellbar. Beim Be- und Entladen eines Wafers 19 aus dem Nest 4a wird unabhängig von der zu bearbeitenden Seite des Wafers 19 der Übergabezylinder 10 über das Verschieben des Außenmantels 26 über einen Stellmotor 37 nach oben gefahren, bis die Anschläge 35 (wenigstens drei) am Kopf 25 an der Innenseite der Kalotte 4 anliegen und sich somit die Halteeinrichtung 40 des Kopfes 25 parallel zum Nest 4a der Kalotte 4 befindet.

Um einen Wafer 19 auf der Halteeinrichtung 40 des Übergabezylinders 10 zu planarisieren, können in der Halteeinrichtung 40 wenigstens eine, vorzugsweise ringförmige, Düse 27 oder mehrere schräg zur Ebene des vorderen Endes ausgerichtete Düsenbohrungen vorgesehen sein, die mit Druckgas beaufschlagt werden, um einen Wafer 19 durch nach dem Bernoulli-Prinzip entstehenden Kräfte an die Halteeinrichtung 40 des Übergabezylinders 10 hin zu ziehen und zu planarisieren. Der innere Teil 28 des Kopfes 25 des Übergabezylinders 10 ist auf den Achsen 36 ebenfalls über einen Betätiger 37, z.B. eines Druckmittelmotors oder desgleichen, auf und ab verschiebbar, so dass der Vakuumkopf 21 und die Referenzanschläge 22 durch das Nest 4a der Kalotte 4 bewegt werden können, um den Wafer 19 beim entsprechenden Prozess über das Nest 4a zu übernehmen oder abzugeben.

Der Übergabezylinder 10 wird also durch axiales Verstellen seines Außenzylinders 26 von innen her gegen den Rand eines Nestes 4a bewegt, bis die Zapfen 35 am Rand des Nestes 4a anliegen und gleichzeitig den Kopf 25 parallel zum Nest 4a ausrichten. Sobald dies geschehen ist, kann durch Betätigen des Druckmittelmotors 37 der innere Teil 28 des Kopfes 25 auf den Gleitstangen 36 geführt ausgefahren, um mit den Referenzanschlägen 22 einen Wafer 19 vom Beladelöffel 15 zu übernehmen oder an den Entladelöffel 12 abzugeben. Beim Anheben und Absenken eines Wafers 19 aus dem bzw. in das Nest 4a wird der innere Teil 28 des Kopfes 25 des Übergabezylinders 10, nicht aber die Halteeinrichtung 40, in der die Bernoullidüse 27 und der Vakuumkopf 21 vorgesehen ist, bewegt, da letztere an den Führungsstangen 36 befestigt ist. Das bedeutet, dass zum Übernehmen eines Wafers 19 von einem Beladelöffel 15 bzw. zum Übergeben eines Wafers an einen Entladelöffel 12 ausschließlich der außerhalb des feststehenden Teils 40 angeordneten Teil 28 des Kopfes 25 des Übergabezylinders 10 mit den Anschlägen 22 bzw. 30 bewegt wird. Dies bedeutet im Ergebnis, dass der Vakuumkopf 21 und die Referenzanschläge 22 ausfahren. Der Wafer 19 wird dann durch den Vakuumkopf 21 angezogen und gehalten und liegt gleichzeitig auf den Referenzanschlägen 22 auf.

Wie bereits erwähnt wurde, ist jedem Nest 4a in den Kalotten 4 eine Vorrichtung 100 zum Festlegen eines Wafers 19 in dem Nest 4a zugeordnet. Diese Klemmvorrichtungen 100 können beispielsweise die in den Fig. 4 und 5 gezeigte Ausführungsform besitzen.

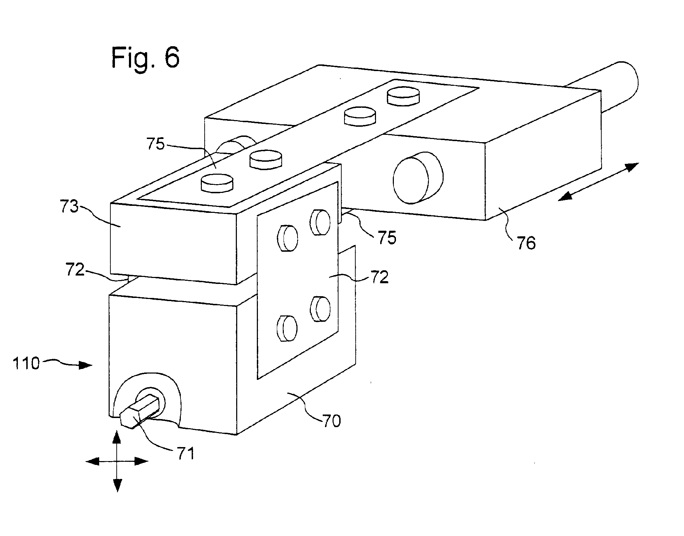

Bei der in Fig. 4 gezeigten Ausführungsform ist eine im wesentlichen runde Scheibe 50 vorgesehen, die nach allen Richtungen kippbar an einem Schwenkarm 51 gehaltert ist. Hierzu ist an der Scheibe 50 ein Bolzen 52 befestigt, der ein doppelt konisches Loch 53 im freien Ende des Schwenkhebels 51 durchsetzt. Weiterhin ist eine Feder 54 vorgesehen, die zwischen der Scheibe 50 und dem freien Ende des Schwenkarms 51 angeordnet ist. Der Schwenkarm 1 ist um ein Lager 56 verschwenkbar, das neben dem Nest 4a an der Kalotte 4 montiert ist. Hierzu können nachstehend noch näher beschriebene Antriebe (vgl. Fig. 6) verwendet werden. Oberhalb der Scheibe 50 ist eine im wesentlichen runde Zentrierplatte 57, beispielsweise eine solche aus dünnem elastischem Blech vorgesehen, die von der Feder 54 gegen einen Vorsprung 58 an der Außenseite der Scheibe 50 gedrückt wird. Beim Nachuntenschwenken des Schwenkhebels 51 um die Klemmvorrichtung 100 zu betätigen, gelangt zunächst die elastische Zentrierplatte 57 mit ihren nach unten abgewinkelten Rändern 59 in Anlage an den Umgebungsbereich des Nestes 4a, so dass die Scheibe 50 parallel zum Nest 4a ausgerichtet wird und damit beim Schließen vollständig in der Neststufe 4b des Nestes 4a einrastet. Der Schwenkhebel 51 wird so weit verschwenkt, dass die Feder 52 etwas zusammengedrückt wird, so dass die Scheibe 50 elastisch gegen einen auf der Stufe im Nest 55 randseitig aufliegenden Wafer 19 gedrückt wird.

Bei der in Fig. 5 gezeigten Ausführungsform einer Klemmvorrichtung 100 zum Festlegen eines Wafers 19 in einem Nest 4a einer Kalotte 4 ist ein Klemmring 60 vorgesehen, der über elastische Verbindungsmittel, z.B. Blattfedern 61, an den Enden eines bogenförmigen Haltebügels 62 befestigt ist. Der Haltebügel 62 seinerseits ist über einen Schwenkhebel 63 und eine den Schwenkhebel 63 tragende Welle 65 in einem Schwenklager 64 gelagert. Im Bereich des Lagers 64 ist eine Feder 66 vorgesehen, welche so vorgespannt ist, dass sie den Klemmring 60 in seine Wirkstellung, in der ein Wafer an der Stufe am Rand des Nestes 4a aufliegend geklemmt wird, belastet. Der Klemmring 60 ist in seinem dem Lager 64 gegenüberliegenden Bereich unterbrochen, damit er die Bewegungen eines Löffels 14, 15 nicht behindert.

Der Umstand, dass sowohl bei der in Fig. 4 als auch bei der in Fig. 5 gezeigten Ausführungsform eine Feder 66 vorgesehen ist, welche den Schwenkhebel 51 bzw. den Haltebügel 62 belastet, bewirkt, dass die Scheibe 50 bzw. der Klemmring 60 in seiner einen Wafer 19 im Nest 4a haltenden Wirkstellung gehalten wird, ohne dass hierzu besondere Maßnahmen erforderlich sind.

Zum Öffnen der Klemmvorrichtungen 100 der Ausführungsformen gemäß Fig. 4 und Fig. 5 kann ein beliebiges Werkzeug vorgesehen sein, das an der den Schwenkhebel 51 bzw. den Schwenkbügel 61 tragenden Welle 65 angreift. Beispielsweise ist an dem Werkzeug ein Mehrkant vorgesehen, der in ein entsprechendes Mehrkantloch 67 in der Welle 65 eingreift, um die Klemmvorrichtung 100 zu öffnen.

Eine Ausführungsform für ein Werkzeug 110 zum Öffnen der Klemmvorrichtungen 100 ist in Fig. 6 gezeigt. Diese Einrichtung besitzt einen Motor 70, der einen Mehrkant 71 antreibt. Der Motor 70 ist über zwei elastische Verbindungsmittel, z.B. zwei Blattfedern 72, mit einem Träger 73 verbunden, der seinerseits über Blattfedern 75, die zu den ersten Blattfedern 72 senkrecht ausgerichtet sind, mit einem Halteteil 76 verbunden ist. Das Halteteil 76 ist mit einem Betätigungsroboter (nicht gezeigt) gekoppelt. Durch Verstellen der Vorrichtung 100 gemäß Fig. 6 mit Hilfe des Betätigungsroboters (nicht gezeigt) kann der Mehrkant 71 gegenüber dem Mehrkantloch 67 in der Welle 65 einer Klemmvorrichtung 100 fluchtend ausgerichtet und dann vorgeschoben werden, wobei durch die elastischen Verbindungsmittel (Blattfedern) eine Selbstzentrierung möglich ist, so dass geringe Positionierungsungenauigkeiten ausgeglichen werden.

### Bezugszeichenliste

- 1: Drehtisch
- 2: Halterung
- 3: Adapter
- 4: Aufnahmeeinheit/Kalotte
- 4a: Ausnehmung/Nest
- 5: Drehlager
- 6: Klemme
- 7: Greifer
- 8: Arm
- 9: Lager
- 10: Übergabeeinrichtung/Übergabezylinder
- 11 12: Entladelöffel
- 13: Entladeroboter
- 14: Beladeroboter
- 15: Beladelöffel
- 16: Horde
- 17: Sensor
- 18: Quarzboot
- 19: Halbleiterwafer
- 20: Verschiebevorrichtung
- 21: Vakuumkopf
- 22: Referenzanschlag
- 25: Kopf
- 26: zylindrischer Außenmantel
- 27: Düse
- 28: Innenteil
- 30: ringförmige Blattfeder
- 31: Außenteil
- 35: Anschlag/Zapfen
- 36: Führungsstange/Achse
- 37: Stellmotor/Betätiger
- 40: Halteeinrichtung
- 50: Scheibe
- 51: Schwenkarm
- 52: Bolzen
- 53: Doppelt konisches Loch
- 54: Feder
- 56: Lager
- 57: Zentrierplatte
- 58: Vorsprung
- 59: Rand
- 60: Klemmring
- 61: Blattfeder
- 62: Haltebügel
- 63: Schwenkarm
- 64: Schwenklager
- 65: Welle
- 66: Feder
- 100: Fixiereinrichtung
- 110: Werkzeug

## Patentansprüche

1. Verfahren zum Be- und/oder Entladen von Halbleiterwafern, insbesondere Dünnwafer oder dergleichen, in bzw. aus Aufnahmeeinheiten, bei welchem Halbleiterwafer (19) in oder aus Ausnehmungen (4a) einer Aufnahmeeinheit (4) eingesetzt bzw. - insbesondere nach einem Bearbeitungsschritt - entnommen werden,
**dadurch gekennzeichnet,**
- **dass** der Halbleiterwafer (19) beim Einsetzen und/oder beim Entnehmen in eine bzw. aus einer Ausnehmung (4a) gegenüber der Ausnehmung (4a) jeweils im wesentlichen zentriert angeordnet wird und
- **dass** der Halbleiterwafer (19) während des Einsetzens und/oder Entnehmens in die bzw. aus der Ausnehmung (4a) jeweils in einer zur Ausnehmung (4a) im wesentlichen parallelen und/oder ebenen Ausrichtung gehalten wird.

2. Verfahren nach Anspruch 1, welches zum Be- und/oder Entladen von als Kalotten (4) ausgebildeter Aufnahmeeinheiten (4) mit einer Mehrzahl als Nester (4a) ausgebildeter Ausnehmungen (4a) vorgesehen und geeignet ist.

3. Verfahren nach einem der vorangehenden Ansprüche,
**dadurch gekennzeichnet,**
**dass** der Halbleiterwafer (19) bei einer Bewegung von und/oder zu der Ausnehmung (4a) auf einer Seite (19a) gehalten wird, die nicht zu behandeln ist bzw. nicht behandelt wurde.

4. Verfahren nach einem der vorangehenden Ansprüche,
**dadurch gekennzeichnet,**
**dass** der Halbleiterwafer (19) jeweils durch Einwirken von Unterdruck und/oder von durch strömendes Gas, insbesondere nach dem Bernoulli-Prinzip, entstehende Kräfte ausgerichtet und insbesondere eben gehalten oder planarisiert wird, insbesondere während er bewegt wird.

5. Verfahren nach einem der vorangehenden Ansprüche,
**dadurch gekennzeichnet,**
**dass** der Halbleiterwafer (19) auf einer der Ausnehmung (4a), in welche oder von welcher er einzusetzen bzw. zu entnehmen ist, zugekehrten Unterseite (19a) gehalten wird.

6. Verfahren nach Anspruch 5,
**dadurch gekennzeichnet,**
**dass** der Halbleiterwafer (19) durch Halten an dieser Unterseite (19a) in Bezug auf die Ausnehmung bewegt und/oder zentriert wird.

7. Verfahren nach einem der vorangehenden Ansprüche,
**dadurch gekennzeichnet,**
**dass** die auf den Halbleiterwafer (19) einwirkenden Kräfte während des Ausrichtens gegenüber der Ausnehmung (4a) im wesentlichen aufgehoben werden, insbesondere bevor der Halbleiterwafer (19) endgültig in der Ausnehmung (4a) angeordnet wird oder ist.

8. Verfahren nach einem der vorangehenden Ansprüche,
**dadurch gekennzeichnet,**
**dass** beim Entladen von Halbleiterwafern (19) aus Ausnehmungen (4a) einer Aufnahmeeinheit (4) im wesentlichen in sinngemäß umgekehrter Verfahrensweise vorgegangen wird wie beim Beladen.

9. Verfahren nach einem der vorangehenden Ansprüche,
**dadurch gekennzeichnet,**
**dass** der Halbleiterwafer (19) nach dem Beladen in der Ausnehmung (4a) durch wenigstens in seinem Randbereich auf ihn wirkende und/oder zur Ausnehmung im wesentlichen senkrecht ausgerichtete Kräfte gehaltert, insbesondere geklemmt, wird.

10. Verfahren nach einem der vorangehenden Ansprüche,
**dadurch gekennzeichnet,**
- **dass** die Aufnahmeeinheit (4) in eine Be- bzw. Entladeposition bewegt wird und
- **dass** die zu be- und/oder entladende Ausnehmung (4a) der Aufnahmeeinheit (4) durch Verdrehen der Aufnahmeeinheit (4) um eine Achse in die Be- oder Entladeposition bewegt wird.

11. Verfahren nach einem der vorangehenden Ansprüche,
**dadurch gekennzeichnet,**
**dass** beim Entladen eines Halbleiterwafers (19) aus einer Ausnehmung (4a) der Aufnahmeeinheit (4) der Halbleiterwafer (19) jeweils in einer im wesentlichen parallelen und/oder ebenen Lage zur Ausnehmung (4a) gehalten wird, vorzugsweise durch strömendes Gas und/oder durch nach dem Bernoulli-Prinzip entstehende Kräfte, bevor den Halbleiterwafer (19) jeweils in der Ausnehmung (4a) halternde und/oder klemmende Kräfte aufgehoben werden.

12. Vorrichtung zum Be- und/oder Entladen von Halbleiterwafern, insbesondere Dünnwafer oder dergleichen, in bzw. aus Aufnahmeeinheiten, insbesondere gemäß einem Verfahren nach einem der Ansprüche 1 bis 11,
**dadurch gekennzeichnet,**
- **dass** eine Halteeinrichtung (6, 7, 8) für mindestens eine Aufnahmeeinheit (4) vorgesehen ist, mit welcher die Aufnahmeeinheit (4) in eine Be- und/oder eine Entladeposition bewegbar ist,
- **dass** im Bereich der Be- und/oder der Entladeposition mindestens eine Übergabeeinrichtung (10) vorgesehen ist, welche in Richtung einer Achse einer Ausnehmung (4a) in der Aufnahmeeinheit (4) gegenüber der Ausnehmung (4a) verstellbar ist und
- **dass** wenigstens eine Beladeeinrichtung (15) und/oder wenigstens ein Entladeeinrichtung (12) zum Bewegen von Halbleiterwafern (19) zu bzw. von einer in der Be- bzw. Entladeposition befindlichen Aufnahmeeinheit (4) vorgesehen sind.

13. Vorrichtung nach Anspruch 12, welche zum Be- und/oder Entladen von als Kalotten (4) oder dergleichen ausgebildeter Aufnahmeeinheiten (4) mit einer Mehrzahl als Nester (4a) oder dergleichen ausgebildeter Ausnehmungen (4a) vorgesehen und geeignet ist.

14. Vorrichtung nach einem der Ansprüche 12 oder 13,
**dadurch gekennzeichnet,**
**dass** die Übergabeeinrichtung im wesentlichen als Übergabezylinder (10) oder dergleichen ausgebildet ist oder mindestens einen solchen aufweist.

15. Vorrichtung nach einem der Ansprüche 12 bis 14,
**dadurch gekennzeichnet,**
**dass** die mindestens eine Beladeeinrichtung (15) und/oder die mindestens eine Entladeeinrichtung (12) jeweils im wesentlichen als Be- bzw. als Entladelöffel (15, 12) oder dergleichen ausgebildet sind oder jeweils einen solchen aufweisen.

16. Vorrichtung nach einem der Ansprüche 12 bis 15,
**dadurch gekennzeichnet,**
**dass** die Beladeeinrichtung (15) aus einer einem ersten Halbleiterwaferreservoir (16), insbesondere einer Horde (16) oder dergleichen, zugeordneten Stellung in die der Be- und/oder Entladeposition der Aufnahmeeinheit (4) zugeordneten Stellung und von dort zurück bewegbar ausgebildet ist.

17. Vorrichtung nach einem der Ansprüche 12 bis 16,
**dadurch gekennzeichnet,**
**dass** die Entladeeinrichtung (12) aus einer der Be- bzw. Entladeposition der Aufnahmeeinheit (4) zugeordneten Stellung in eine einem zweiten Halbleiterwaferreservoir (18), insbesondere einem Quarzboot (18) oder dergleichen, und/oder einer Horde (16) zugeordneten Stellung und von dort zurück bewegbar ausgebildet ist.

18. Vorrichtung nach einem der Ansprüche 12 bis 17,
**dadurch gekennzeichnet,**
**dass** zum Bewegen der Be- und/oder Entladeeinrichtung (15, 12) jeweils mindestens eine Bewegungseinrichtung (14, 13) vorgesehen ist.

19. Vorrichtung nach Anspruch 18,
**dadurch gekennzeichnet,**
**dass** als Bewegungseinrichtung (14, 13) jeweils ein Bewegungsroboter (14, 13) oder dergleichen vorgesehen ist.

20. Vorrichtung nach einem der Ansprüche 12 bis 19,
**dadurch gekennzeichnet,**
**dass** mindestens eine Haltevorichtung zum Halten mindestens einer Aufnahmeeinheit (4) in der Be- und/oder Entladeposition vorgesehen ist.

21. Vorrichtung nach Anspruch 20,
**dadurch gekennzeichnet,**
- **dass** die mindestens eine Haltevorrichtung mindestens einen verschwenkbaren Arm (8) aufweist oder als solcher ausgebildet ist und
- **dass** an dem Arm (8) ein von innen her an der Aufnahmeeinheit (4) anlegbarer Greifer (7) oder dergleichen und/oder eine an der Aufnahmeeinheit (4) außen an einem vorgesehenen Adapter (3) oder dergleichen angreifende Klemme (6) oder dergleichen vorgesehen sind.

22. Vorrichtung nach einem der Ansprüche 12 bis 21,
**dadurch gekennzeichnet,**
**dass** durch den Arm (8) die Aufnahmeeinheit (4) um ihre Achse verdrehbar halterbar ist.

23. Vorrichtung nach einem der Ansprüche 12 bis 22,
**dadurch gekennzeichnet,**
**dass** der Arm (8) in einem Lager (9) um eine Achse, gegebenenfalls durch motorischen Antrieb oder dergleichen, verschwenkbar ausgebildet ist.

24. Vorrichtung nach einem der Ansprüche 12 bis 23,
**dadurch gekennzeichnet,**
**dass** der Haltevorrichtung zum Haltern von Aufnahmeeinheiten (4), insbesondere bestehend aus dem Arm (8), dem vorzugsweise selbstzentrierenden Greifer (7) und der Klemme (6), ein Drehtisch (1) mit mehreren Halterungen (2) für Adapter (3) einer Mehrzahl von Aufnahmeeinheiten (4) zugeordnet vorgesehen ist.

25. Vorrichtung nach einem der Ansprüche 12 bis 24,
**dadurch gekennzeichnet,**
**dass** der in der Be- bzw. Entladestellung befindlichen Ausnehmung (4a) der Aufnahmeeinheit (4) eine Übergabeeinrichtung (10), insbesondere ein Übergabezylinder (10) oder dergleichen, zugeordnet vorgesehen ist.

26. Vorrichtung nach einem der Ansprüche 12 bis 25,
**dadurch gekennzeichnet,**
**dass** die Übergabeeinrichtung (10), insbesondere der Übergabezylinder (10), einen Kopf (25) aufweist, der in eine zur Ebene der Ausnehmung (4a) parallele Lage oder Anordnung verstellbar ausgebildet ist.

27. Vorrichtung nach einem der Ansprüche 12 bis 26,
**dadurch gekennzeichnet,**
**dass** an dem der Ausnehmung (4a) zugekehrten Ende der Übergabeeinrichtung (10) wenigstens ein Vakuumkopf (21) und/oder wenigstens eine Düse (27) für den Austritt von Druckgas vorgesehen sind.

28. Vorrichtung nach Anspruch 27,
**dadurch gekennzeichnet,**
**dass** der Vakuumkopf (21) und/oder die Düse (27) zum Erzeugen von Kräften nach dem Bernoulli-Prinzip ausgebildet sind.

29. Vorrichtung nach einem der Ansprüche 11 bis 28,
**dadurch gekennzeichnet,**
**dass** an dem der Ausnehmung (4a) jeweils zugekehrten Ende der Übergabeeinrichtung (10) Referenzanschläge (22) vorgesehen sind, welche gegenüber der Ausnehmung vorschiebbar ausgebildet sind.

30. Vorrichtung nach einem der Ansprüche 12 bis 29,
**dadurch gekennzeichnet,**
**dass** der Kopf (25) der Übergabeeinrichtung (10) an einem äußeren, in etwa zylindrischen Teil (26) der Übergabeeinrichtung (10) im wesentlichen elastisch verschwenkbar gehaltert ist.

31. Vorrichtung nach einem der Ansprüche 12 bis 30,
**dadurch gekennzeichnet,**
**dass** an dem Kopf (25) mehrere Anlagestifte (35) vorgesehen sind, welche zum Zentrieren des Kopfes (25) der Übergabeeinrichtung (10), insbesondere im Umfangsbereich einer Ausnehmung (4a), an der Aufnahmeeinheit (4) anlegbar vorgesehen sind.

32. Vorrichtung nach einem der Ansprüche 12 bis 31,
**dadurch gekennzeichnet,**
**dass** jeder Ausnehmung (4a) der Aufnahmeeinheit (4) eine einen Halbleiterwafer (19) in der Ausnehmung (4a) fixierende Fixiereinrichtung (110), insbesondere als eine in das Nest (4a) klemmende Vorrichtung, zugeordnet vorgesehen ist.

33. Vorrichtung nach Anspruch 32,
**dadurch gekennzeichnet,**
**dass** die Fixiervorrichtung (110), insbesondere zum Klemmen eines Halbleiterwafers (19) in einem Nest (4a), eine an einem Schwenkhebel (51) gegenüber diesem kippbar gelagerte Scheibe (50) aufweist.

34. Vorrichtung nach Anspruch 33,
**dadurch gekennzeichnet,**
**dass** mit Abstand von der Scheibe (50) unterhalb des Schwenkhebels (51) eine Zentrierscheibe (57) mit nach unten abgewinkeltem Rand (59) vorgesehen ist, um die Scheibe (50) gegenüber dem Halbleiterwafer (19) parallel zu stellen, bevor die Scheibe (50) am Halbleiterwafer (19) anliegt.

35. Vorrichtung nach einem der Ansprüche 31 bis 34,
**dadurch gekennzeichnet,**
**dass** die Fixiervorrichtung (110) einen, insbesondere wenigstens einmal unterbrochenen, Klemmring (60) aufweist.

36. Vorrichtung nach Anspruch 35,
**dadurch gekennzeichnet,**
**dass** der Klemmring (60) über einen Haltebügel (62) und einen Schwenkhebel (63) an der Aufnahmeeinheit (4), insbesondere Kalotte (4), verschwenkbar gelagert ist.

37. Vorrichtung nach Anspruch 36,
**dadurch gekennzeichnet,**
**dass** der Klemmring (60) mit dem Haltebügel (62) durch elastische Mittel, insbesondere durch Blattfedern (61) oder dergleichen, verbunden ist.
